# EUROPÄISCHE PATENTSCHRIFT

(11) **EP 0 579 686 B1**
(45) Veröffentlichungstag und Bekanntmachung des Hinweises auf die Patenterteilung: **17.09.1997**
(21) Anmeldenummer: 92908426.7
(22) Anmeldetag: 11.04.1992
(51) Int. Cl.: H03F 3/50, H03F 3/30

(54) **WANDLERSCHALTUNG**
TRANSDUCER CIRCUIT
CIRCUIT DE TRANSDUCTEUR

(30) Priorität: 12.04.1991 DE 4111999
(43) Veröffentlichungstag der Anmeldung: 26.01.1994
(73) Patentinhaber: Thomson Consumer Electronics Sales GmbH, 30453 Hannover (DE)
(72) Erfinder: KÖLLNER, Hartmut, D-30167 Hannover (DE)
(86) Internationale Anmeldenummer: EP9200824
(87) Internationale Veröffentlichungsnummer: WO9219040

(56) Entgegenhaltungen:
- EP-A- 0 209 987
- EP-A- 0 394 807
- DE-A- 3 035 471
- GB-A- 1 059 112
- US-A- 4 771 227
- NEW ELECTRONICS.INCORPORATING ELECTRONICS TODAY. Bd. 19, Nr. 22, November 1986, LONDON GB Seite 18; L. SAGE: 'HIGH PERFORMANCE BUFFER'

## Beschreibung

Die Erfindung betrifft eine Wandlerschaltung, bestehend aus einem ersten Transistor, dessen Basis ein Eingangssignal zuführbar ist, einem zweiten. zum ersten Transistor komplementären Transistor, dessen Basis mit dem Emitter des ersten Transistors verbunden ist und dessen Emitter über einen ersten Widerstand mit einer Ausgangsklemme verbunden ist und mit einer Stromzuführungsschaltung, die einen im wesentlichen gleichen Stromfluß durch die Emitter-Kollektor-Strecken sicherstellt.

Eine derartige Wandlerschaltung ist durch die DE 30 35 471 C2 bekannt. Die dort in Figur 3 dargestellte Schaltung besteht somit aus zwei kaskadenförmig zusammengeschalteten Emitterfolgern. Aufgrund der positiven Temperaturkoeffizienten des verwendeten Bipolartransistors muß der Ruhestrom in komplemetären Stufen durch den eine Stromgegenkopplung bildenden ersten Widerstand stabilisiert werden. Hierdurch kommt es zu einem ausgangsstromabhängigen Spannungsabfall an dem Gegenkopplungswiderstand, was zu einer Spannungsaussteuerungsminderung führt, da der Steuerspannungshub größer als der Ausgangsspannungshub ist. Damit hat der Emitterfolger dieser Konfiguration nicht die geforderten Eigenschaften eines idealen Impedanzwandlers, nämlich einen sehr geringen Ausgangswiderstand, der gegen Null geht. In einer bekannten Schaltungstechnik wird der Nachteil des begrenzt niedrigen Ausgangswiderstandes häufig durch starke Gegenkoppelung über alle Stufen (Spannungs- und Stromverstärkerstufen) des Wandlers kompensiert.

Es ist ferner versucht worden, die negative Wirkung des Stromgegenkopplungswiderstandes an diesem selbst zu mindern, z. B. durch Überbrücken des Widerstandes mit Dioden, durch Stromentlastungsschaltungen oder Quad-Brückenschaltungen. Alle diese Schaltungen benötigen aber regelmäßig aufwendige Ruhestromstabilisierungen, selektierte Transistoren und (bei der Quad-Schaltung) ein aufwendig zu dimensionierendes Schaltungskonzept. Die Diodenübertragung wirkt erst ab einer Spannung von 0,6 V, der Ruhestrom muß unter 0,6 V liegen, so daß die Ruhestromeinstellung nicht frei wählbar ist. Für Komplementärverstärker kommt es im A- bzw. AB-Betrieb zu Übernahmeverzerrungen. Die Stromentlastungsschaltungen gestatten nur mit einem relativ großen Aufwand eine Näherung an den Ausgangswiderstand Null.

Das eingangs erwähnte Schaltungskonzept hat den Vorteil, daß die zueinander inversen Emitterfolger, die mit im wesentlichen gleichen Strömen durchflossen werden, eine Kompensation der nichtlinearen Kennlinien der Transistoren bewirken. Das bekannte Schaltungskonzept wird regelmäßig für nichtverzerrende Verstärker eingesetzt, erlaubt jedoch keine Ausbildung als dem Ideal angenäherter Impedanzwandler.

Der Erfindung liegt die Aufgabe zugrunde, eine Wandlerschaltung der eingangs erwähnten Art so auszubilden, daß ein Ausgangswiderstand von praktisch Null erreichbar ist und die Steuerkennlinienverzerrungen vollständig kompensiert sind.

Diese Aufgabe wird durch die im Anspruch 1 angegebene Erfindung gelöst. Vorteilhafte Weiterbildungen der Erfindung sind in den abhängigen Ansprüchen angegeben.

Durch die Zeitschrift "NEW ELECTRONICS, INCORPORATING ELECTRONICS TODAY", Bd. 19, Nr. 22, November 1986, LONDON GB Seite 18; ist eine Wandlerschaltung bekannt, die ebenfalls einen vom Eingangssignal an der Basis gesteuerten ersten Transistor, einen zweiten, vom ersten Transistor gesteuerten Transistor, einen Widerstand zwischen dem Emitter des zweiten Transistors und der Ausgangsklemme, eine Stromzuführungsschaltung für den ersten Transistor sowie einen zweiten Widerstand zwischen dem Emitter des ersten Transistors und der Basis des zweiten Transistors aufweist. Bei dieser Schaltung ist jedoch keine Stromrückführungsschaltung vom Ausgang des Wandlers vorgesehen.

Durch die Einfügung des erfindungsgemäßen Widerstandes in die Verbindung zwischen dem Emitter des ersten Transistors und der Basis des zweiten Transistors so, daß durch den zweiten Widerstand der Emitter-KollektorStrom des ersten Transistors hindurchfließt, bewirkt eine automatische Kompensation des Spannungsabfalls über dem als Stromgegenkopplungswiderstand wirkenden ersten Widerstand, in dem die Spannung an der Basis des zweiten Transistors durch den Spannungsabfall über dem ersten Widerstand exakt kompensiert werden, wenn die beiden Widerstände gleich groß sind. Durch eine geeignete Dimensionierung des zweiten Widerstandes relativ zu dem ersten Widerstand können aber auch beliebige positive oder negative Ausgangswiderstände des Wandlers eingestellt werden. Selbstverständlich müssen bei einem negativen Ausgangswiderstand Sicherheitsmaßnahmen vorgesehen werden.
Durch die unterschiedliche Polarität des Eingang- und Ausgangstransistors und den damit verbundenen unterschiedlichen Arbeitspunkten bei gleichen Strömen ist die Kompensation begrenzt.
Um zwischen den Eingangs- und Ausgangstransistoren bei gleichen Strömen eine vollständige Kennliniensymmetrie zu schaffen werden beiden jeweils ein komplementärer als Diode geschalteter Transistor in Serie als Kompensationswiderstand hinzugefügt. Beide Kennlinien (Transistor und Diode) ergeben zusammengefügt eine neue, für beide Seiten gleiche Steuerkennlinie, die vollständig kompensierbar ist.
Die Stromzuführungsschaltung beinhaltet vorzugsweise einen an sich bekannten Stromspiegel mit zwei mit ihren Basen miteinander verbundenen Transistoren.

Eine besonders vorteilhafte Ausführungsform der erfindungsgemäßen Schaltung läßt sich dadurch realisieren, daß die beiden Transistoren des Stromspiegels eine unterschiedliche Polarität aufweisen, so daß sie die gleiche Polarität aufweisen wie der ihnen jeweils zugeordnete, vom gleichen Strom durchflossene erste bzw. zweite Transistor In diesem Fall ist es nämlich möglich, die beiden jeweils vom gleichen Strom durchflossenen Transistoren als identische Doppeltransistoren vor einem gemeinsamen Substrat auszubilden, wodurch gleiche Eigenschaften und gleiche Kennlinien der beiden Transistoren sichergestellt sind.

Dabei kann es zweckmäßig sein, wenn der erste Transistor zusammen mit dem zweiten Widerstand und dem zugehörigen Transistor des Stromspiegels eine Konfiguration mit zwei gleichpoligen Transistoren und einem zwischengeschalteteten Widerstand bildet, die invers am zweiten Transistor zusammen mit einem zwischengeschaltetem Widerstand und dem zugehörigen Transistor des Stromspiegels realisiert ist. Auf diese Weise läßt sich das erfindungsgemäße Schaltungskonzept mit zwei Doppeltransistoren ausbilden.

Die erfindungsgemäße Wandlerschaltung kann als eine komplementäre Wandlerschaltung ausgebildet sein, wodurch sich die Bauteile spiegelbildlich und invers verdoppeln. In dieser Ausführungsform können vier gleiche Konfigurationen hintereinander geschaltete Brückenzweige bilden. Eine völlige Symmetrie in völlig gleicher Ausbildung in jedem Brückenzweig läßt sich dadurch erreichen, daß in jedem Brückenzweig jeweils ein Widerstand hinzugeschaltet ist, dessen Wert dem ersten Widerstand entspricht. In die Brückenschaltung ist dann auch der als Gegenkopplungswiderstand wirkende erste Widerstand integriert.

Die Arbeitspunkteinstellung des Wandlers ist durch eine Vorspannungsquelle wählbar, die mit der Basis des zweiten Transistors verbunden ist. Bei der komplementären Ausbildung der Wandlerschaltung ist die Vorspannungsquelle zwischen den Basen zueinander inversen zweiten Transistoren angeordnet.

Die Vorspannungsquelle kann aber auch in Form eines linearen Widerstandes oder eines spannungsabhängigen Widerstandes in einem ruhestrombegrenzenden Nebenpfad der Schaltung liegen. In diesem Fall läßt sich der Ruhestrom über die ,in einem weiteren Nebenpfad der Schaltung liegenden, Stomquellen einstellen.

Die erfindungsgemäße Schaltung erlaubt eine interne, frei wählbare Ruhe stromeinstellung, ohne die Symmetrie der Schaltung zu stören.

Die erfindungsgemäße Schaltungstechnik erlaubt die Realisierung von universellen Bauteilen mit idealen Eigenschaften. Insbesondere ist die Realisierung von idealen Transistorstrukturen möglich, wobei die vertikale Symmetrie in den mit den ersten und dem zweiten Transistor gebildeten Stromzweigen von entscheidender Bedeutung ist.

Die Erfindung soll im folgenden anhand von in der Zeichnung dargestellten Ausführungsbeispielen näher erläutert werden. Es zeigen:
- Figur 1:: eine komplementäre Impedanzwandlerschaltung
- Figur 2A:: eine schematische Darstellung des prinzipiellen Aufbaus einer Impedanzwandlerschaltung mit einem Stromspiegel aus zwei gleichen Transistoren (horizontale Symmetrie)
- Figur 2B:: eine Variante mit zusätzlichen komplementären Transistordioden unter Ausbildung einer horizontalen Symmetrie
- Figur 3:: eine Variante der Schaltung gemäß Figur 2 A und B mit einer Stromzuführungsschaltung mit komplementären Transistoren unter Ausbildung einer vertikalen Symmetrie
- Figur 4:: eine schematische Darstellung der Schaltung gemäß Figur 3 mit paarweise auf einem gemeinsamen Substrat aufgebauten Transistoren
- Figur 5A:: einen nach dem Prinzip der Figuren 3 und 4 aufgebauten komplementären Impedanzwandler mit einer Stromentlastung und einem schaltungsintenen Ruhestromnebenpfad.
- Figur 5B:: einen nach dem Prinzip der Figuren 3 und 4 aufgebauten komplementären Impedanzwandler mit doppelsymmetrischer Ruhestromeinspeisung
- Figur 5C:: einen nach dem Prinzip der Figur 2B aufgebauten komplementären Impedanzwandler mit gleichen, aber unlinearen Widerständen und einer aktiven Transistorvorspannungsquelle im strombegrenzenden Nebenpfad
- Figur 5D:: einen nach dem Prinzip der Figur 3 und 4 aufgebauten komplementären Impedanzwandler mit aktiver Vorspannungsquelle
- Figur 6:: ein in der Schaltungstechnik der Figuren 3 und 4 aufgebautes universelles Transistorbauteil
- Figur 7A:: ein Bauteil mit lateralem pnp- Transistor
- Figur 7B:: ein Bauteil mit Darlingtonausgangskreis
- Figur 7C:: ein Bauteil gemäß Figur 6 in Hybrid-Technik
- Figur 7D:: ein Bauteil gemäß Figur 6 in MOSFET-Technik ohne zusätzliche Widerstände im Ausgangskreis
- Figur 8A:: einen integrierten Leistungsdarlingtontransistor
- Figur 8B:: einen diskreten Aufbau von Steuerstufe und Stromentlastung
- Figur 8C:: einen kompensierten Source- Folger
- Figur 8D:: einen stromentlasteten Source- Folger
- Figur 9:: ein pnp-Transistorbauteil
- Figur 10:: ein npn-Transistorbauteil
- Figur 11:: ein universell einsetzbarer integrierter Schaltkreis
- Figur 12:: ein Dual-Schaltkreis in komplementärer Technik
- Figur 13:: ein Transistorbauteil mit einer Stromentlastungsschaltung
- Figur 14:: eine gegenüber Figur 13 modifizierte Schaltung mit gleicher Wirkung

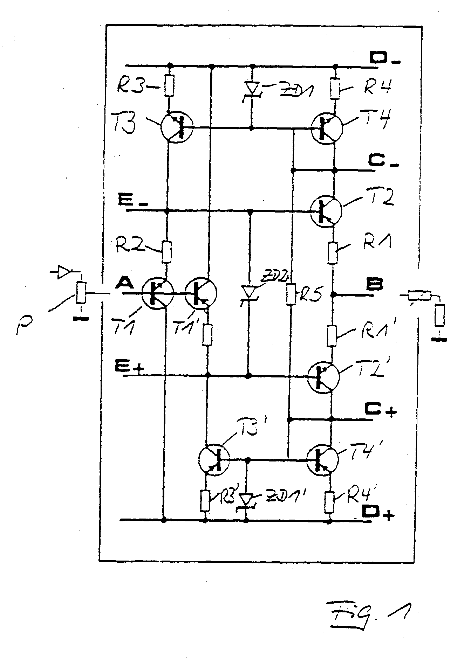

Bei dem in Figur 1 dargestellten Ausführungsbeispiel ist eine Eingangssignalklemme A mit einem Abgriff eines des Eingangssignals zuführenden Potentiometers P verbunden. Mit der Eingangssignalklemme A ist die Basis eines ersten bipolaren Transistors T1, der als npn-Transistor ausgebildet ist, und die Basis eines inversen (pnp) Transistors T1' verbunden. Der Emitter des Transistors T1 ist mit der Basis eines zweiten Transistors T2 verbunden, der (ebenfalls) als Emitterfolger geschaltet ist und dessen Emitter über einen ersten Widerstand R1 mit einer Ausgangsklemme B verbunden ist. In die Verbindung zwischen dem Emitter des ersten Transistors T1 und der Basis des zweiten Transitors T2 ist ein zweiter Widerstand eingeschaltet.

Die Stromzufuhr zu den beiden Transistoren T1 und T2 erfolgt über einen Stromspiegel, der aus zwei mit ihren Basen miteinander verbundenen Transistoren T3 und T4 besteht. Deren Emitter sind jeweils über einen EmitterWiderstand R3 bzw R4 mit einer negativen Versorgungsspannung D- verbunden. Der dem zweiten Transistor T2 zugeordnete Transistor T4 des Stromspiegels ist als Diode geschaltet, weist also eine direkte Verbindung zwischen seinem Kollektor und seiner Basis auf. Dieser an sich bekannte Stromspiegel bewirkt, daß durch die beiden Transistoren T1 und T2 gleiche Ströme fließen. Der Kollektor des ersten Transistors T1 ist dabei mit einer positiven Versorgungsspannung D+ verbunden. Die an dem ersten Widerstand R1 abfallende, mit dem übertragenen Signal variierende Spannung wird in genau der gleichen Größe dem Ausgangssignal hinzuaddiert, wenn der zweite Widerstand R2 gleich groß wie der erste Widerstand R1 gewählt ist. Da durch die beiden Widerstände R1, R2 gleiche Ströme fließen, fallen über sie gleiche Spannungen ab. Die Eingangssignalspannung, die am Emitter des ersten Transistors T1 ansteht, würde ohne den zweiten Widerstand R2 um die am ersten Widerstand R1 abfallende Spannung reduziert werden. Durch die Spannungserhöhung am Widerstand R2 wird die Signalspannung um die am Widerstand R1 abfallende Spannung erhöht, so daß die Spannung E- an der Basis des zweiten Transistors T2 der negativen Signalspannung, erhöht durch den Spannungsabfall am Widerstand R2 (bzw.. R1) entspricht. Bei der erfindungsgemäßen Schaltungsanordnung kompensieren sich daher nicht nur die nichtlinearen Diodenwege der beiden Transistoren T1, T2 sondern auch die Spannungsabfälle an den Widerständen R1, R2 wenn diese gleich groß gewählt sind. Somit läßt sich ein Impedanzwandler mit einem Ausgangswiderstand Null realisieren. Wird der Widerstand R2 < R1 gewählt. verbleibt ein positiver Ausgangswiderstand, während der Ausgangswiderstand negativ wird, wenn R2>R1 gewählt wird.

Die in Figur 1 dargestellte Schaltungsanordnung ist eine komplementäre Anordnung. Die für die positive Signalspannung vorgesehene Schaltungshälfte entspricht der beschriebenen Schaltungshälfte für die negative Signalspannung und ist mit entsprechenden Bezugsziffern, ergänzt durch "'" gekennzeichnet.

Zwischen den Versorgungsspannungen D+ bzw D- und den zugehörigen Basen der Transistoren T3, T4 der Stromspiegel sind jeweils Zehnerdioden ZD1, ZD1' angeordnet, die den maximalen Strom durch die Transistoren T1, T2 bzw die Transitoren T3, T4 begrenzen, falls beispielsweise an der Ausgangsklemme ein Kurzschluß entstehen sollte.

Eine zwischen die Basen der beiden zweiten Transistoren T2 und T2' geschaltete Zehnerdiode ZD2 legte den Arbeitspunkt auf den Kennlinien der beiden Transistoren T2, T2' fest. Ein mit den Kollektoren der beiden Transistoren T4, T4'verbundener Widerstand R5 bildet einen Ruhestromnebenpfad und ermöglicht eine Ruhestrom beim Einschalten der Schaltung.

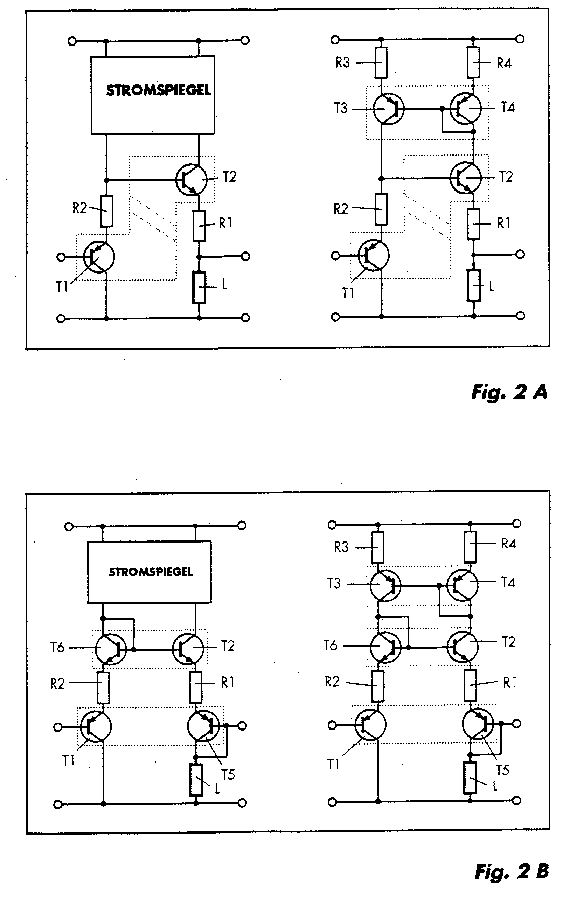

Figur 2A veranschaulicht die Prinzipschaltung, die in Figur 1 verwirklicht worden ist. Die beiden möglichst gleichen Transistoren T3, T4 bilden den Stromspiegel und sorgen für einen gleichgroßen Strom durch die Transistoren T1, T2, die komplementär zueinander ausgebildet sind.

Um für jeden Arbeitspunkt der Schaltung das gewünschte Ergebnis zu erzielen, müsen nicht nur die Kennlinien der Transitoren T3, T4 gleich sein sondern möglichst auch die Kennlinine der komplementären Transistoren T1, T2. Die Schaltung beruht somit auf einer horizontalen Symmetrie zwischen den Transistorpaaren T3, T4 und T1, T2. Die Einhaltung dieser Symmetriebedingung ist für die komplementären Transistoren T1, T2 nur angenähert möglich.

Figur 2B zeigt wie der Eingangs- und Ausgangstransistor durch jeweils einen komplementären Diodentransistor (T5,T6) ergänzt sind. Durch die Hintereinanderschaltung zweier unterschiedlicher Diodenstrecken ergibt sich bei horizontaler Symmetrie von Transistor und Diodentransistor auf beiden Seiten die gleiche Steuerkennlinie.Die Schaltung ist horizontalsymmetrisch aufgebaut und erreicht bei hinreichend genauer Fertigung der Transistoren eine vollständige Kompensation der Steuerkennlinienverzerrungen.

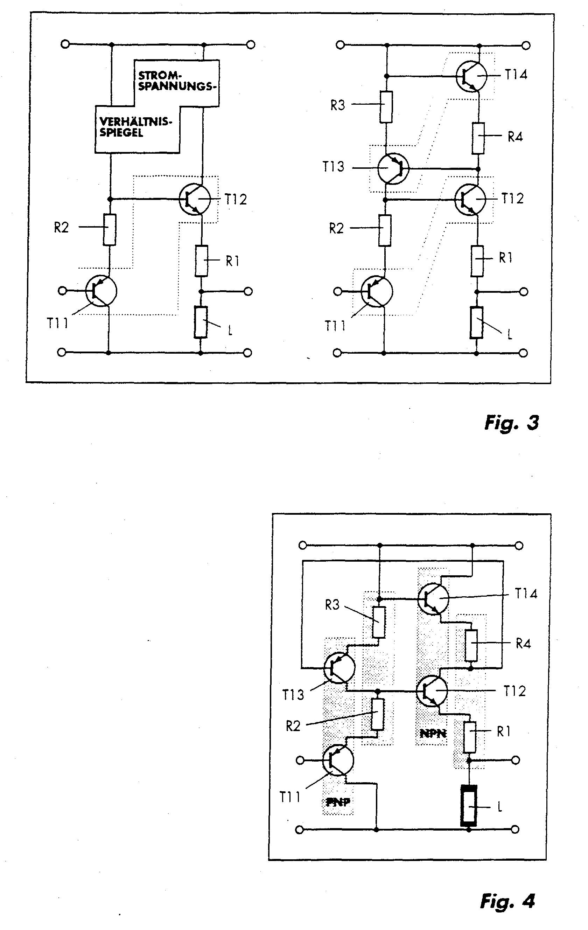

Figur 3 zeigt eine Variante der Schaltung gemäß Figur 2. die auf einem anderen Funktionsprinzip beruht. Transistoren T11 und T12 sind in der gleichen Weise miteinander verschaltet wie die Transistoren T1 und T2 in der Schaltung gemäß Figur 2. In gleicher Weise wie der Transistor T3 in Figur 2 ist ein Transistor T13 in Serie mit der Kollektor-Emitter-Strecke des Transistors T11 angeordnet. Ein Transistor T14 ist hingegen in anderer Polarität als der Transistor T13 ausgebildet und mit seinem Emitter über den Widerstand R4 mit dem Kollektor des Transistors T12 verbunden. Bei diesem Schaltungsaufbau ergibt sich eine vertikale Symmetrie, da die Transistoren T11 und T13 in gleicher Polarität, nämlich als pnp-Transistoren und die Transistoren T12 und T14 als npn-Transistoren ausgebildet sind. Figur 4 verdeutlicht, daß die pnp-Transistoren T11, T13 zweckmäßigerweise auf einem gemeinsamen Chip aufgebaut werden, so daß sie ein völlig gleiches Kennlinienverhalten zueinander aufweisen können. In gleicher Weise werden die npn-Transistoren T12,T14 auf einem gleichen Chip aufgebaut. Die Widerstände R1, R2, R3, R4 können paarweise ebenfalls gleich aufgebaut sein, so daß sich eine vollkommene vertikale Symmetrie ergibt. Das Funktionsprinzip dieser Schaltung beruht nun nicht mehr darauf, daß in den beiden Transistoren T1, T2 durch den Stromspiegel völlig gleiche Ströme hindurchfließen sondern darauf, daß durch die vertikale Symmetrie die Verschaltung nach Art einer Brücke erfolgt, in der gleiche Teilstreckenspannungen bestehen, so daß die an der Basis des Transistors T11 gegen Bezugspotential anstehende Eingangsspannung gleich der über einem Lastwiderstand L anstehende Ausgangsspannung ist. Dabei können in den beiden Stromzweigen T11, T13 bzs. T12, T14 durchaus unterschiedliche Ströme fließen, ohne die Kompensation der nichtlinearen Kennlinien der Transistoren T11 bis T14 zu stören. Dabei müssen die Widerstände R1 bis R4 entsprechend den unterschiedlichen Strömen dimensioniert sein. Die Schaltungen gemäß Figuren 3 und 4 verwenden somit komplementär aufgebaute "Stromspiegel" und beruhen auf einem vertikal symmetrischen Aufbau, bei dem die gleichen fehlerbehafteten pnp-Transistoren auf der einen Seite durch zwei (im allgemeinen anders) fehlerbelastete, aber gleiche npn-Transistoren auf der anderen Seite genau kompensiert werden.

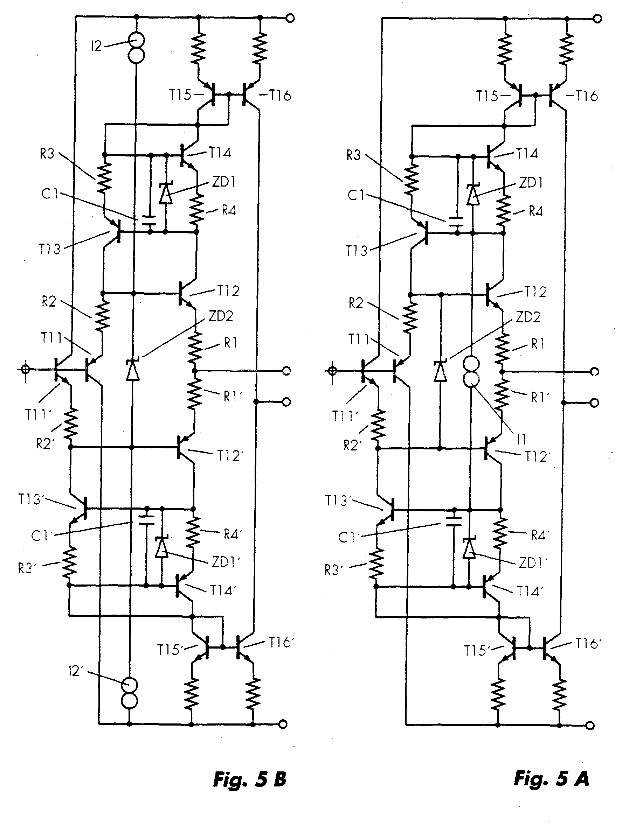

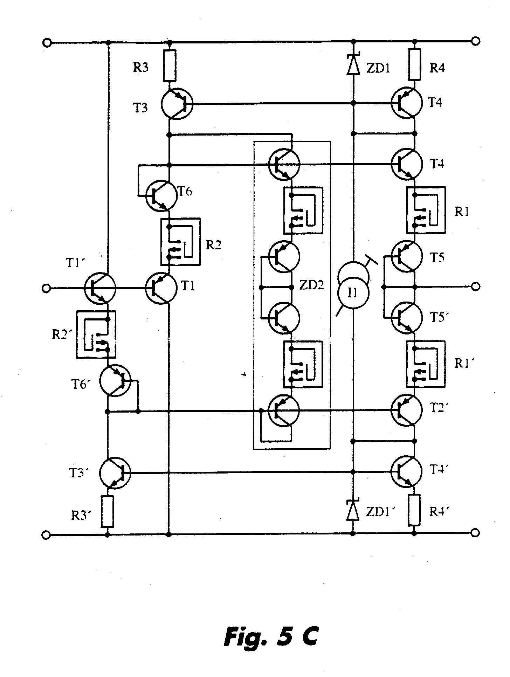

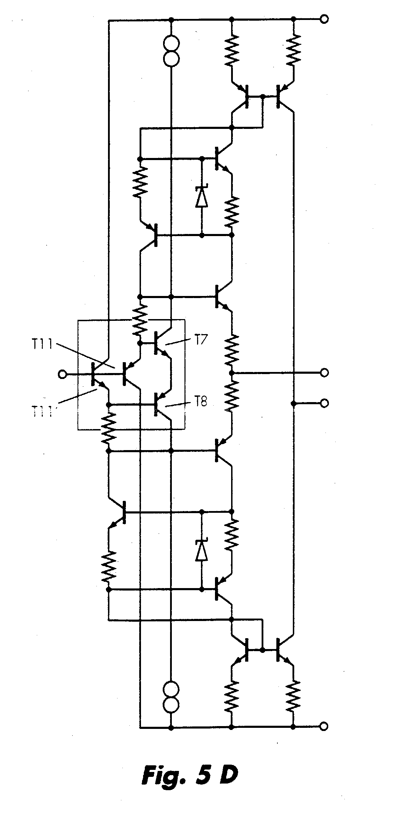

Figur 5A zeigt eine Schaltung, die wesentlich dem Schaltungsaufbau gemäß Figur 1 entspricht, wobei jedoch das Schaltungsprinzip gemäß den Figuren 3 und 4 realisiert ist. Durch jeweils eine der Zehnerdiode ZD1, ZD1' parallel geschaltete Kapazität C1, C1' wird eine frequenzabhängige Mitkopplungskompensation vorgenommen. Durch einen aus zwei Transistoren T15, T16 bzw T15', T16'gebildeten Leistungsstromsppiegel kann der komplementäre Impedanzwandler vom Leistungsstrom entlastet werden und dient somit lediglich als Steuerschaltung. Die Stromquelle 11 in einem Nebenstrompfad der Schaltung sorgt dafür, daß erst einmal beim Einschalten der Versorgungsspannung (Ub) ein Ruhestrom in der Schaltung zustande kommt. Im eingeschalteten Zustand fließt der Strom der Stromquelle 11 über die komplementären Stromspiegel (T13,T14;T13',T14') in die Vorspannungsquelle ZD2.
Figur 5B zeigt, wie eine zusätzliche Ruhestrombelastung der komplementären Stromspiegel ,die die vertikale Symmetrie stört, zu vermeiden ist. Die beiden gleich gewichteten Stromquelle( I2,I2') speisen den Strom direkt in die Vorspannungsquelle ZD2 ein.
Für die Vorspannungsquelle ZD2 ist auch ein weniger niederimpedantes Bauteil einsetzbar wie zum Beispiel ein einfacher Widerstand,da hier ein begrenzender Ruhestromgegenkopplungskreis besteht. Der Widerstand kann nur soviel Strom aufnehmen, wie über die Stromquellen (I2 oder I1) fremdeingespeist wird. Jeder weitere Spannungsanstieg über dem Widerstand ist mit einem Stromabzug aus der-Schaltung verbunden,der sich in einer Herabsetzung der Mitkoppelungseffizienz der ganzen Schaltung äußert. Dieser Vorgang stabilisiert den Ruhesstrom.

Über die Stromquellen ist auch eine Offset-Trimmung möglich.

Figur 5C zeigt eine Schaltung, die gemäß Figur 2B realisiert wurde. Die linearen Widerstände sind durch Feldeffekttransistordioden ersetzt,die in ihrem Spannungs-Stromverhalten unlinear sind. Auf diese Weise werden spannungsabhängige Widerstände erzielt, die in ihren Kennlinien und dem damit verbundenen Innenwiderstand untereinander gleich sind. Die Symmetrie bleibt erhalten.
Der Grund für die Verwendung unlinearer Widerstände liegt in der unsymmetrischen Spannungs- und Stromverteilung zwischen dem oberen und unteren Teil der komplementären Schaltung .Bei einer Signalaussteuerung findet bei gleichen schaltungsinternen Spannungshüben im oberen und unteren Teil der Schaltung ein um einige Größenordnungen höherer Strom gewinn im (z. B.) oberen Teil der Schaltung statt,als dieser im unteren Teil an Stomminderung bewirkt. Die Schaltung arbeitet in einem dynamisch erweiterten Klasse- A Bereich und benötigt so für eine bestimme Ausgangsleistung einen geringeren Ruhestrom.
Die Vorspannungsquelle ZD 2 ist als Diodenstrecke im ruhestrombegrezenden Nebenpfad der Schaltung ausgeführt.

Figur 5D zeigt eine aktive, thermisch gekoppelte Transistorvorspannungsquelle (T7, T8) in einer Schaltung gemäß Figur 5B. Die Vorspannungstransistorquellen stellen einen hochsteilen spannungsgesteuerten Widerstand dar, der durch die Spannung über den beiden Basisanschlüssen der komplementären Transistoren gesteuert wird. Ein übermäßiger Ruhestrom- oder Stromanstieg wird auch entsprechend übermäßig über die Kollektorleitungen in einen Nebenpfad, eben der Vorspannungsquelle,ab. geleitet.

Die erfindungsgemäße Schaltungsanordnung in der strengen vertikalen Symmetrie erschließt universelle Anwendungsmöglichkeiten.

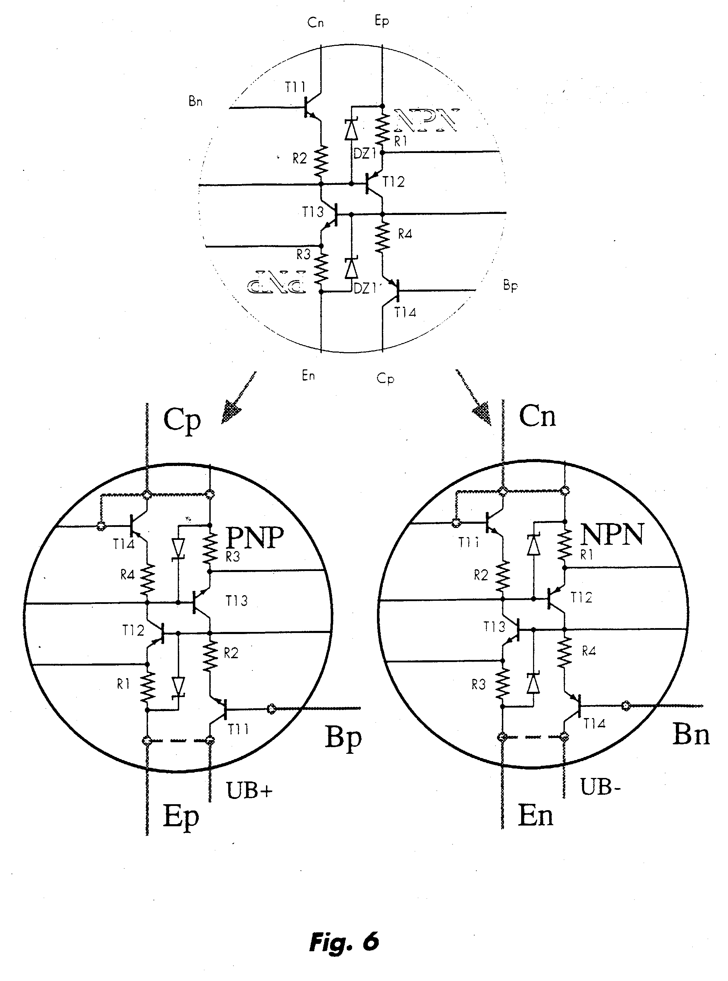

Figur 6 zeigt ein unverdrahtetes Bauteil, dessen Schaltungstechnik Figur 3 entspricht.Die Verbindung des Versorgungsspannungsanschlusses Ub des ersten Transistors (T11,T14) mit dem Emitter des zweiten Transistors (T12,T13) spart einen Außenanschluß des Bauteils.

Der Basisanschluß Bp des Transistors T14 kann dabei als Basis einer npn-Transistorstruktur beschaltet werden. Durch Zusammenschaltung des Kollektors Cn und der Basis Bn des Transistors T11 (Cn) mit dem Emitter-Anschluß des Transistors T12 am freien Ende des Widerstands R1 (Ep) und des Kollektors des Transistors T14 (Cp) mit dem Emitter Anschluß des Transistors T13 jenseits des Widerstandes R3 (En) bilden diese beiden Zusammenschlüsse Emitter und Kollektor des npn-Transistors.

Das Bauteil gemäß Figur 6 kann in ähnlicher Weise als pnp-Transistor verwendet werden, wofür die Basis des Transistors T11 (bn) als Basiseingang verwendet wird.
Die übrigen Anschlüsse der universellen Struktur gemäß der Figur 6 können zu Kompensations- und Trimmzwecken verwendet werden.

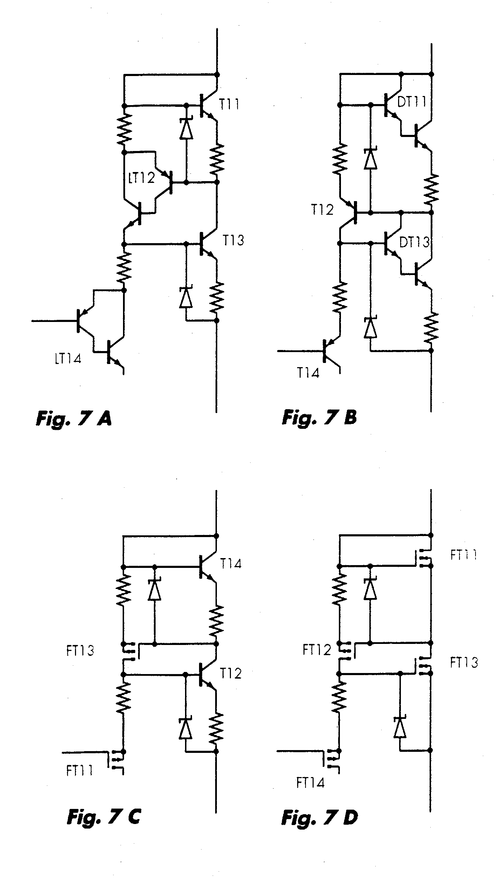

Die Figuren 7A bis 7D zeigen verschiedene gemischt zusammengesetzte Bauteile mit aufrecht erhaltener vertikaler Symmetrie.
Figur 7D zeigt ein entsprechendes Bauteil in MOSFET-Technik mit entsprechenden Feldeffekttransistoren FT11 bis FT14 und zusatzwiderstandslosem Ausgangskreis.Dies ist bei genügend hohem Innenwiderstand der Transistorquelle und hinreichender Kennliniengleichheit beider Transistoren (FT11,FT13) möglich.

Da es unter den vertikalen Symmetriebedingungen ausschließlich auf die Identität der miteinander in Serie geschaltete Verstärkungsbauteile ankommt, ist das universelle Bauteil gemäß Figur 6 auch unkompliziert in einer Hybrid-Technik ausführbar, wobei beispielsweise zwei Feldeffetkttransistoren FT11 und FT13 mit zwei bipolaren Transistoren T12 und T14 zu einem Bauteil kombiniert werden.

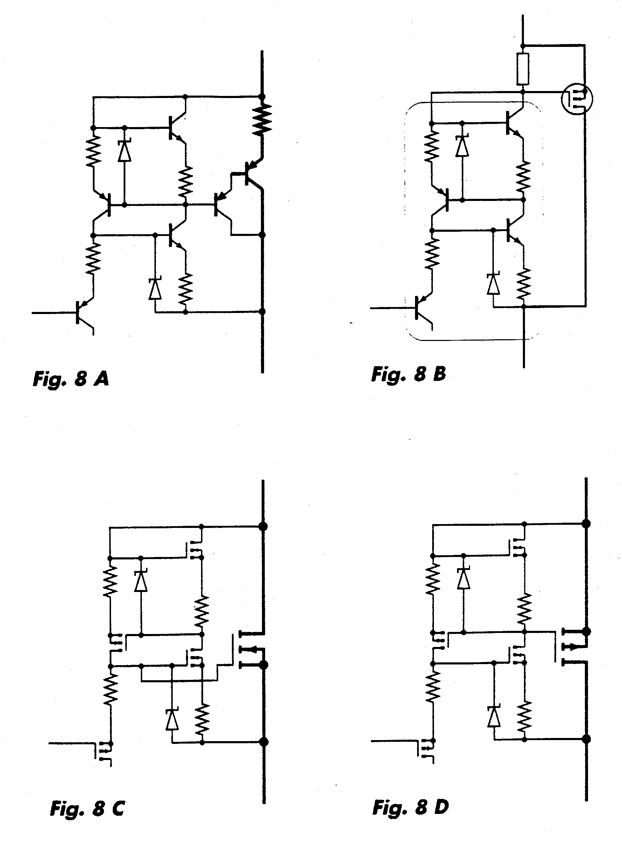

Die Figuren 8A bis 8D zeigen unterschiedliche Leistungstransistoranwendungen,wobei der universale Schaltkreis sowohl als Steuerstufe für eine an sich unlinear arbeitende Leistungsstromquelle dient. als auch zur Steuerspannungsvorentzerrung für einen Leistungsemitter- oder Sourcefolger.

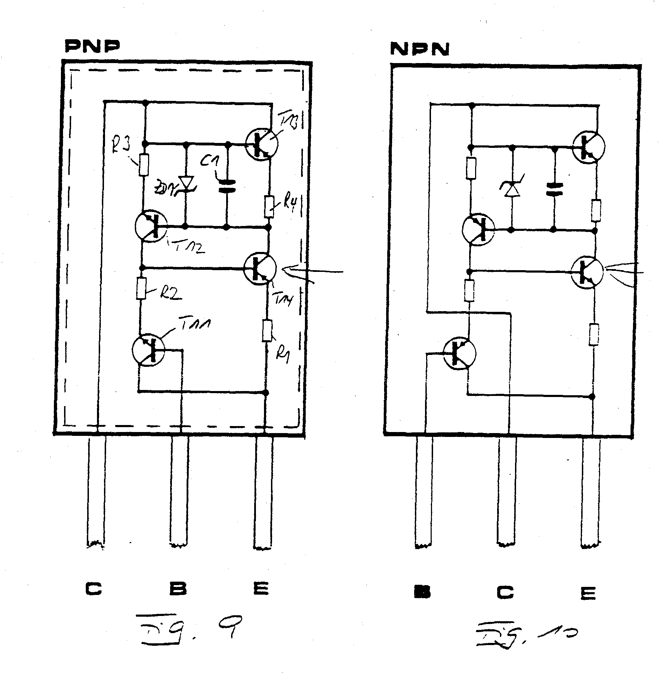

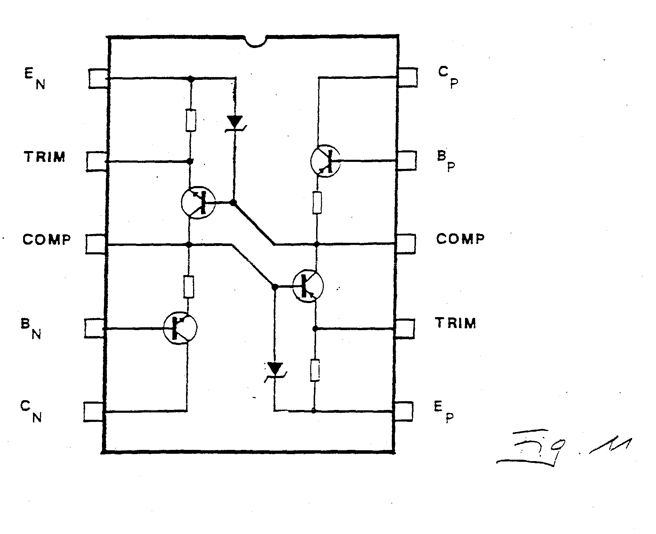

In den Figuren 9 und 10 sind zwei spezielle Transistorschaltungen in pnp- und npn-Technik gezeigt. Die beiden Schaltungen unterscheiden sich lediglich durch die komplentäre Ausbildung der Transistoren T11 bis T14. Sie bilden synthetisch lineare Transistor-Ersatzstrukturen.

Figur 11 zeigt die in Figur 6 dargestellte universelle Struktur in einer Ausbildung einer integrierten Schaltung mit symmetrisch angeordneten Zehnerdioden ZD1 und ZD3 als Schutzdioden.

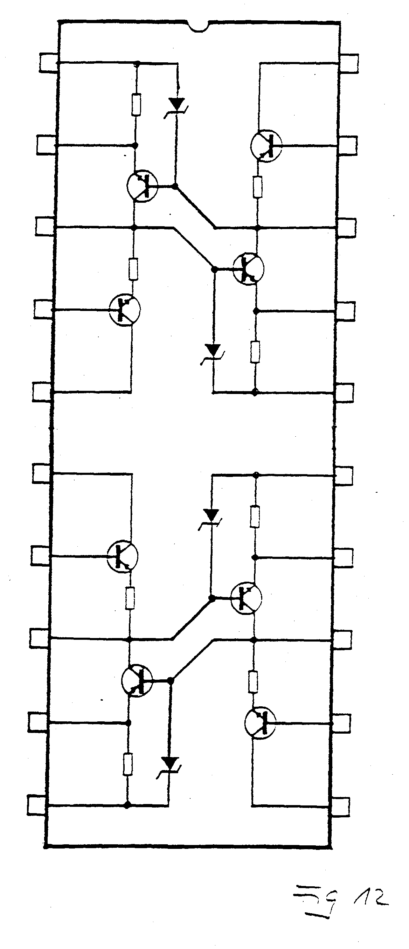

Die komplementär verdoppelte Ausbildung des Schaltkreises gemäß Figur 11 führt zu dem in Figur 12 dargestellten Schaltkreis, der nicht vorverdrahtet ist und somit über zwanzig Anschlüsse verfügt. Durch eine interne Vorverdrahtung kann die Zahl der Anschlüsse naturgemäß ohne Schwierigkeiten verringert werden.

Es ist erkennbar, daß die in den Figuren 6 bis 12 dargestellten Strukuren universell verwendbar sind und lediglich in Abhängigkeit von der externen Beschaltung vielfältige Einsatzmöglichkeiten erschließen. Insbesondere lassen sich ideale, also ausgangsspannungsverlustfreie Transistoren realisieren, die bei Einhalten der vertikalen Symmetrie gemäß den Figuren 3 und 4 vollständig kennlinien- und temperaturkompensiert sind. Die Anwendungsmöglichkeiten derartiger Bauelemente und ihre Vorteile erschließen sich ohne weitere Erläuterung.

Es ist ohne weiteres möglich, die Transistoren gemäß den Figuren 9 und 10 gleich als Leistungsstransistoren auszubilden, in dem die Transistoren T13 und T14 in einer Darlington-Schaltung ausgebildet und somit für Leistungszwecke geeignet sind. Selbstverständlich ist es dabei auch möglich, die Transistoren T11 und T12 als Darlington-Schaltungen auszubilden, um somit eine vollständige Darlington-Struktur zu erzugen, die zu einer internen Basisstromerniedrigung führt.

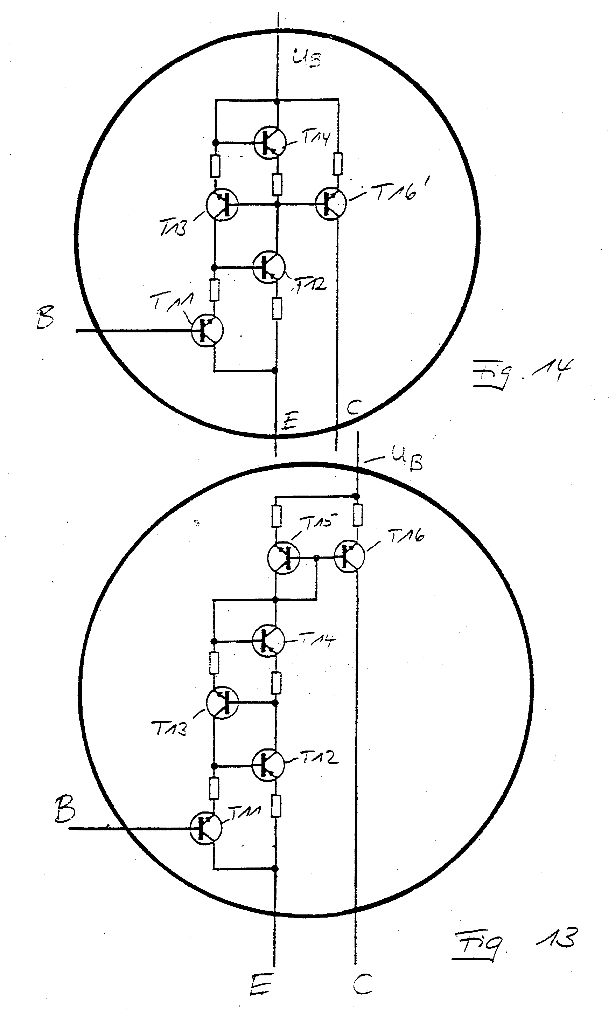

Figur 13 zeigt eine synthetische Transistor-Ersatzstruktur, die mit einer Wandlerschaltung, wie sie prinzipiell in Figur 3 dargestellt ist, aufgebaut ist. Diese bildet an der Basis des Transistors T11 einen Basisanschluß B und an dessen Kollektor einen Emitter-Anschluß E. Ein Kollektoranschluß C ist über einen weiteren Stromspiegel T15, T16 von der Wandlerschaltung entkoppelt. Dem Stromspiegel wird eine Versorgungsspannung UB über einen gesonderten Anschluß zugeführt. die sich hieraus ergebende Transistorstruktur mit den Anschlüssen B, E und C erlaubt die gleiche Einstellung der Ruhe-Spannungspotentiale an allen drei Anschlüssen B, E und C.

Figur 14 zeigt ebenfalls eine Transistor-Ersatzstruktur mit den Anschlüssen B, E, und C wobei die Stromentlastung mit einem Transistor T16' vorgenommen wird, der zusammen mit dem Transistor T14 einen Stromspiegel bildet. Der Transistor T14 wird also für zwei Stromspiegel T13, T14 und T14, T16' doppelt ausgenutzt. Über die Kollektor-Basis-Kapazität des Transistors T16' findet eine kapazitive Kollektor-Rückwirkung zur Wandlerschaltung statt.

Die in den Figuren 13 und 14 dargestellten Bauteile erlauben eine Spannungsverstärkung, bei der die verstärkte Spannung an gleichen Potentialen abnehmbar ist wie die Eingangspotentiale, so daß mehrere Stufen ohne weiteres hintereinander schaltbar sind.

## Patentansprüche

1. Wandlerschaltung, bestehend aus einem ersten Transistor (T1, T1', T11, T11'; FT11), dessen Basis ein Eingangssignal zuführbar ist, einem zweiten, zum ersten Transistor (T1, T1'; T11 T11'; FT11) komplementären Transistor (T2, T2'; T12, T12'), dessen Basis mit dem Emitter des ersten Transistors (T1, T1'; T11, T11'; FT11) verbunden ist und dessen Emitter über einen ersten Widerstand (R1) mit einer Ausgangsklemme (B) verbunden ist, und mit einer Stromrückführungsschaltung (T3, T4, T3'; T4'; T13, T14; T13', T14'; FT13, FT14) vom Ausgang, die den Stromfluß durch die Emitter-Kollektor-Strecken der beiden Transistoren (T1, T1'; T11, T11'; T2, T2'; T12. T12') in proportionaler Abhängigkeit voneinander steuert, gekennzeichnet durch einen mit dem Emitter des ersten Transistors (T1, T1'; T11, T11'; FT11) verbundenen zweiten Widerstand (R2, R2'), der vom Kollektor-Emitter-Strom des ersten Transistors (T1, T1'; T11, T11'; FT11) durchflossen ist und über den der Emitter des ersten Transistors (T1, T1'; T11, T11'; FT11) mit der Basis des zweiten Transistors (T2, T2'; T12, R12') verbunden ist.

2. Wandlerschaltung nach Anspruch 1, **dadurch gekennzeichnet,** daß der zweite Widerstand (R2; R2') und der erste Widerstand (R1, R1') jeweils durch einen komplementären, als Diode geschalteten Transistor (T5, T6; T5', T6') in Serie ergänzt sind.

3. Wandlerschaltung nach Anspruch 2, **dadurch gekennzeichnet,** daß die Stromrückführungsschaltung einen Stromspiegel mit zwei mit ihren Basen miteinander verbundenen Transistoren (T3, T4; T3', T4'), beinhaltet.

4. Wandlerschaltung nach Anspruch 1, **dadurch gekennzeichnet,** daß die Transistoren der Stromrückführungsschaltung die gleiche Polarität aufweisen, wie der ihm jeweils zugeordnete, vom gleichen Strom durchflossene erste bzw. zweite Transistor (T11, T11'; FT11; T12, T12').

5. Wandlerschaltung nach Anspruch 1, 2 oder 4, **dadurch gekennzeichnet,** daß die beiden jeweils vom gleichen Strom durchflossenen Transistoren als gleiche Doppelstransistoren auf einem gemeinsamen Substrat ausgebildet sind.

6. Wandlerschaltung nach Anspruch 5, **dadurch gekennzeichnet,** daß alle, zueinander symmetrisch ausgerichtete Transistoren und deren Widerstände auf einem gemeinsamen Substrat ausgebildet sind.

7. Wandlerschaltung nach einem der Ansprüche 1 - 6, **dadurch gekennzeichnet,** daß der zweite Widerstand (R2, R2') relativ zum ersten Widerstand (R1, R1') dimensioniert ist und bei R1 > R2 einen positiven Ausgangswiderstand, bei R1 < R2 einen negativen Ausgangswiderstand und bei R1 = R2 einen Ausgangswiderstand von Null hervorruft.

8. Wandlerschaltung nach Anspruch 3, **dadurch gekennzeichnet**, daß die beiden Transistoren (T3, T4; T3', T4') des Stromspiegels je einen Widerstand (R3, R4; R3', R4') im Emitter enthalten und diese Widerstände relativ zueinander dimensioniert sind und den Ausgangswiderstand festlegen.

9. Wandlerschaltung nach Anspruch 8, **dadurch gekennzeichnet,** daß der erste Widerstand (R1) und der zweite Widerstand (R2) je zusammen mit einem Widerstand (R4, R3) des Stromspiegels vom selben Strom durchflossen sind und den Ausgangswiderstand festlegen.

10. Wandlerschaltung nach einem der Ansprüche 1 und 4 bis 9, **dadurch gekennzeichnet,** daß der erste Transistor (T11, T11') zusammen mit dem zweiten Widerstand (R2, R2') und einem zugehörigen Transistor (T13, T13') der Stromrückführungsschaltung eine Konfiguration mit zwei gleichpoligen Transistoren und einem zwischengeschalteten Widerstand bildet, die invers am zweiten Transistor (T12, T12') zusammen mit einem zwischengeschalteten Widerstand (R1, R1') und einem zugehörigen Transistor (T14, T14') der Stromrückführungsschaltung realisiert ist.

11. Wandlerschaltung nach einem der Ansprüche 1 - 10, **dadurch gekennzeichnet,** daß eine Vorspannungsquelle (ZD1, ZD1') zur Verlustleistungsbegrenzung die zwischen Basis und Emitterwiderstand der Transistoren der Stromrückführungsschaltung geschaltet ist.

12. Wandlerschaltung nach Anspruch 1, **dadurch gekennzeichnet,** daß eine Vorspannungsquelle (ZD2) zur Ruhestromeinstellung zwischen den Basen von zwei zueinander inversen zweiten Transistoren (T2, T2'; T12, T12') angeordnet ist.

13. Wandlerschaltung nach Anspruch 12, **dadurch gekennzeichnet,** daß die Vorspannungsquelle zur Ruhestromeinstellung ein linearer Widerstand ist.

14. Wandlerschaltung nach Anspruch 12, **dadurch gekennzeichnet,** daß die Vorspannungsquelle zur Ruhestomeinstellung ein spannungsabhängiger Widerstand ist.

15. Wandlerschaltung nach Anspruch 13 oder 14, **dadurch gekennzeichnet**, daß der zur Ruhestromeinstellung dienende Widerstand mit der übrigen Schaltung thermisch gekoppelt ist.

16. Wandlerschaltung nach einem der Ansprüche 1 - 15, **dadurch gekennzeichnet,** daß die Betriebsspannung (UB) für die Wandlerschaltung über eine durch einen Stromspiegel gebildete Stromentlastungsschaltung (T15, T16; T15', T16') zugeführt ist.

## Claims

1. Converter circuit consisting of a first transistor (T1, T1', T11, T11'; FT11) to the base of which an input signal can be fed, a second transistor (T2, T2'; T12, T12') which is complementary to the first transistor (T1, T1'; T11, T11'; FT11) and the base of which is connected to the emitter of the first transistor (T1, T1'; T11, T11'; FT11) and the emitter of which is connected via a first resistor (R1) to an output terminal (B) and the circuit including a current feedback circuit (T3, T4, T3'; T4'; T13, T14; T13', T14'; FT13, FT14) from the output which controls the current flow through the emitter collector paths of the two transistors (T1, T1', T11, T11'; T2, T2'; T12, T12') in proportional dependence on one another, characterised by a second resistor (R2, R2') which is connected to the emitter of the first transistor (T1, T1'; T11, T11'; FT11), is traversed by the collector emitter current of the first transistor (T1, T1'; T11, T11'; FT11) and via which the emitter of the first transistor (T1, T1'; T11, T11'; FT11) is connected to the base of the second transistor (T2, T2'; T12, T12').

2. Converter circuit in accordance with Claim 1, characterised in that, the second resistor (R2, R2') and the first resistor (R1, R1') are each expanded by a respective complementary transistor (T5, T6; T5', T6') which is connected-up as a diode and is connected in series therewith.

3. Converter circuit in accordance with Claim 2, characterised in that, the current feedback circuit incorporates a current mirror including two transistors (T3, T4; T3', T4') having their bases connected together.

4. Converter circuit in accordance with Claim 1, characterised in that, the transistors in the current feedback circuit have the same polarity as the respective first or second transistor (T11, T11'; FT11; T12, T12') that is associated therewith and is traversed by the same current.

5. Converter circuit in accordance with any of the Claims 1, 2 or 4, characterised in that, the respective two transistors that are traversed by the same current are constructed as equivalent double transistors on a common substrate.

6. Converter circuit in accordance with Claim 5, characterised in that, all of the mutually symetrically oriented transistors and their resistors are formed on a common substrate.

7. Converter circuit in accordance with any of the Claims 1-6, characterised in that, the second resistor (R2, R2') is dimensioned relative to the first resistor (R1, R1') and gives rise to a positive output resistance when R1 > R2, a negative output resistance when R1 < R2 and a zero output resistance when R1 = R2.

8. Converter circuit in accordance with Claim 3, characterised in that, the two transistors (T3, T4; T3', T4') in the current mirror each include a resistor (R3, R4; R3, R4') in the emitter and these resistors are dimensioned relative to one another and determine the output resistance.

9. Converter circuit in accordance with Claim 8, characterised in that, the first resistor (R1) and the second resistor (R2) together with a respective resistor (R4, R3) in the current mirror are each traversed by the same current and determine the output resistance.

10. Converter circuit in accordance with any of the Claims 1 and 4 - 9, characterised in that, the first transistor (T11, T11') together with the second resistor (R2, R2') and an appertaining transistor (T13, T13') in the current feedback circuit are configured as two like-poled transistors and an intermediately connected resistor, this configuration being implemented inversely by the second transistor (T12, T12') together with an intermediately connected resistor (R1, R1') and an appertaining transistor (T14, T14') in the current feedback circuit.

11. Converter circuit in accordance with any of the Claims 1 to 10, characterised in that, a bias voltage source (ZD1, ZD1') for limiting power losses is connected between the base and emitter resistor of the transistors in the current feedback circuit.

12. Converter circuit in accordance with Claim 1, characterised in that, a bias voltage source (ZD2) for setting the quiescent current is arranged between the bases of two mutually inverse second transistors (T2, T2'; T12, T12').

13. Converter circuit in accordance with Claim 12, characterised in that, the bias voltage source for setting the quiescent current is a linear resistor.

14. Converter circuit in accordance with Claim 12, characterised in that, the bias voltage source for setting the quiescent current is a voltage dependent resistor.

15. Converter circuit in accordance with Claim 13 or 14, characterised in that, the resistor that is used for setting the quiescent current is thermally coupled to the remainder of the circuit.

16. Converter circuit in accordance with any of the Claims 1 to 15, characterised in that, the operating voltage (UB) for the converter circuit is supplied via a current balancing circuit (T15, T16; T15', T16') formed by a current mirror.

## Revendications

1. Circuit de transducteur composé d'un premier transistor (T1, T1' ; T11, T11' ; FT11) à la base duquel un signal d'entrée peut être amené, d'un deuxième transistor (T2, T2' ; T12, T12') complémentaire du premier (T1, T1' ; T11, T11' ; FT11) dont la base est reliée à l'émetteur du premier transistor (T1, T1' ; T11, T11' ; FT11) et dont l'émetteur est relié via une première résistance (R1) à une borne de sortie (B), et à un circuit de retour de courant (T3, T4, T3' ; T4' ;T13, T14 ; T13', T14' ; FT13, FT14) à partir de la sortie, qui dirige la conduction de courant dans les trajets émetteur - collecteur des deux transistors (T1, T1', T11, T11', T2, T2', T12, T12') en dépendance réciproque proportionnelle, **caractérisé par** une deuxième résistance (R2, R2') reliée avec l'émetteur du premier transistor (T1, T1' ; T11, T11' ; FT11) qui est traversée par le courant collecteur - émetteur du premier transistor (T1, T1' ; T11, T11' ; FT11) et via laquelle l'émetteur du premier transistor (T1, T1' ; T11, T11'; FT11) est relié à la base du deuxième transistor (T2, T2' ; T12, T12').

2. Circuit de transducteur d'après la revendication 1 **caractérisé en ce que** la deuxième résistance (R2, R2') et la première résistance (R1, R1') sont complétées chacune par un transistor complémentaire (T5, T6 ; T5', T6') commuté comme diode, en série.

3. Circuit de transducteur d'après la revendication 2 **caractérisé en ce que** le circuit de retour de courant comprend un miroir de courant avec deux transistors reliés entre eux par leur base (T3, T4 ; T3', T4').

4. Circuit de transducteur d'après la revendication 1 **caractérisé en ce que** les transistors du circuit de retour de courant présentent la même polarité que le premier ou le deuxième transistor (T11, T11'; FT11; T12, T12') traversé par le même courant qui lui correspond.

5. Circuit de transducteur d'après la revendication 1, 2 ou 4 **caractérisé en ce que** les deux transistors traversés par le même courant sont formés comme des doubles transistors égaux sur un substrat commun.

6. Circuit de transducteur d'après la revendication 5 **caractérisé en ce que** tous les transistors installés symétriquement les uns par rapport aux autres et leurs résistances sont formés sur un substrat commun.

7. Circuit de transducteur d'après une des revendications 1 à 6 **caractérisé en ce que** la deuxième résistance (R2, R2') est dimensionnée relativement à la première résistance (R1, R1') et appelle une résistance de sortie positive pour R1 > R2, négative pour R1 < R2 et nulle pour R1 = R2.

8. Circuit de transducteur d'après la revendication 3 **caractérisé en ce que** les deux transistors (T3, T4 ; T3', T4') du miroir de courant contiennent chacun une résistance (R3, R4 ; R3', R4') dans l'émetteur et ces résistances sont dimensionnées relativement les unes par rapport aux autres et définissent la résistance de sortie.

9. Circuit de transducteur d'après la revendication 8 **caractérisé en ce que** la première résistance (R1) et la deuxième résistance (R2) avec une résistance (R4, R3) du miroir de courant sont chacune traversées par le même courant et définissent la résistance de sortie.

10. Circuit de transducteur d'après une des revendications 1 et 4 à 9 **caractérisé en ce que** le premier transistor (T11, T11') avec la deuxième résistance (R2, R2') et un transistor associé (T13, T13') du circuit de retour de courant forme une configuration avec deux transistors de même polarité et une résistance intercalée, qui est réalisée inversement pour le deuxième transistor (T12, T12') avec une résistance intercalée (R1, R1') et un transistor associé (T14, T14').

11. Circuit de transducteur d'après une des revendications 1 à 10 **caractérisé en ce que** une source de tension de polarisation (ZD1, ZD1') est commutée entre la base et la résistance d'émetteur des transistors du circuit de retour de courant pour limiter la puissance dissipée.

12. Circuit de transducteur d'après la revendication 1 **caractérisé en ce que** une source de tension de polarisation (ZD2) est affectée entre les bases de deux seconds transistors (T2, T2' ; T12, T12') inverses l'un par rapport à l'autre pour la mise au point du courant de repos.

13. Circuit de transducteur d'après la revendication 12 **caractérisé en ce que** la source de tension de polarisation pour la mise au point du courant de repos est une résistance linéaire∗.

14. Circuit de transducteur d'après la revendication 12 **caractérisé en ce que** la source de tension de polarisation pour la mise au point du courant de repos est une résistance nonlinéaire.

15. Circuit de transducteur d'après la revendication 13 ou 14 **caractérisé en ce que** la résistance servant à la mise au point du courant de repos est en couplage thermique avec le reste du circuit.

16. Circuit de transducteur d'après une des revendications 1 à 15 **caractérisé en ce que** la tension de fonctionnement (UB) pour le circuit de transducteur est amenée via un circuit de déchargement de courant (T15, T16 ; T15', T16') formé par un miroir de courant.
